# EUROPÄISCHE PATENTSCHRIFT

(11) **EP 1 263 274 B1**
(45) Veröffentlichungstag und Bekanntmachung des Hinweises auf die Patenterteilung: **04.03.2009**
(21) Anmeldenummer: 02008346.5
(22) Anmeldetag: 12.04.2002
(51) Int. Cl.: H05K 5/00, H05K 5/06

(54) **Gehäuse für ein elektrisches Gerät, insbesondere ein Schalt- oder Steuergerät in einem KFZ**
Casing for electric apparatus, particularly for switching a control unit in vehicle
Boîtier pour un appareil électrique, uneunité de commande ou de contrôle dans un véhicule

(30) Priorität: 30.05.2001 DE 10126189
(43) Veröffentlichungstag der Anmeldung: 04.12.2002
(73) Patentinhaber: ROBERT BOSCH GMBH, 70442 Stuttgart (DE)
(72) Erfinder: Mayer, Frank, 71640 Ludwigsburg (DE); Schiefer, Peter, 74199 Unterheinriet (DE)

(56) Entgegenhaltungen:
- EP-A- 0 861 019
- DE-A- 10 045 728
- DE-A- 19 505 123
- DE-A- 19 839 928
- FR-A- 2 716 767

## Beschreibung

### Stand der Technik

Die Erfindung betrifft ein elektrisches Gerät, insbesondere ein Schalt- oder Steuergerät in einem KFZ, nach dem Oberbegriff des Anspruchs 1, wie es bereits bekannt ist. Um die Gehäuseteile sowie den Steckerkörper dicht miteinander zu verbinden, damit das Eindringen von Feuchtigkeit in das Steuergerätinnere vermieden wird, werden die einzelnen Bauteile des Steuergerätes in der Praxis unter Zwischenlage einer flexiblen Dichtung miteinander verbunden (DE 195 16 708 A1 oder DE 10 045 728 A1). Fertigungskritisch sind dabei jedoch diejenigen Fügestellen, an denen mehr als zwei Teile, im vorliegenden Fall die beiden Gehäuseteile und der Steckerkörper, unmittelbar aufeinandertreffen, da sich in diesem Bereich Fertigungs- und Montagetoleranzen summieren. In der Serienfertigung kann es dadurch zu Abdichtproblemen kommen.

### Vorteile der Erfindung

Das erfindungsgemäße elektrische Gerät, insbesondere Schaltoder Steuergerät in einem KFZ, mit den kennzeichnenden Merkmalen des Anspruchs 1 hat demgegenüber den Vorteil, daß ein sicheres Abdichten des Steuergerätes nach außen hin erzielt wird. Dies wird erfindungsgemäß im wesentlichen dadurch erreicht, daß im Fügebereich, in dem die mehr als zwei Bauteile unmittelbar aneinandertreffen, ein Vorsprung des Steckerkörpers in eine mit Dichtmasse versehene Ausnehmung des einen Gehäuseteils eingreift. Dadurch wird die Dichtmasse gezielt in Richtung zum anderen Gehäuseteil hin verdrängt, so daß im Fügebereich der drei Bauteile zueinander stets ein bestimmtes Volumen an Dichtmasse vorhanden ist.

Vorteilhafte Weiterbildungen des.erfindungsgemäßen Gehäuses für ein elektrisches Gerät, insbesondere ein Schalt- oder Steuergerät in einem KFZ, sind in den Unteransprüchen angegeben.

### Zeichnung

Ein Ausführungsbeispiel der Erfindung ist in der Zeichnung dargestellt und wird nachfolgend näher erläutert. Es zeigen:
Figur 1 ein Steuergerät für ein KFZ mit einem erfindungsgemäßen Gehäuse in Explosionsdarstellung,
Figur 2 einen Schnitt durch das Steuergerät nach Anspruch 1 im kritischen Fügebereich,
Figur 3 einen Teil des Gehäusedeckels nach Figur 1 in perspektivischer Ansicht,
Figur 4 den Gehäusedeckel nach Figur 3 nach dem Aufbringen einer Dichtmasse und
Figur 5 den Gehäusedeckel nach Figur 4 mit der Darstellung der Anordnung der Dichtmasse im Gehäuseboden, jedoch ohne den Gehäuseboden selbst.

### Beschreibung des Ausführungsbeispiels

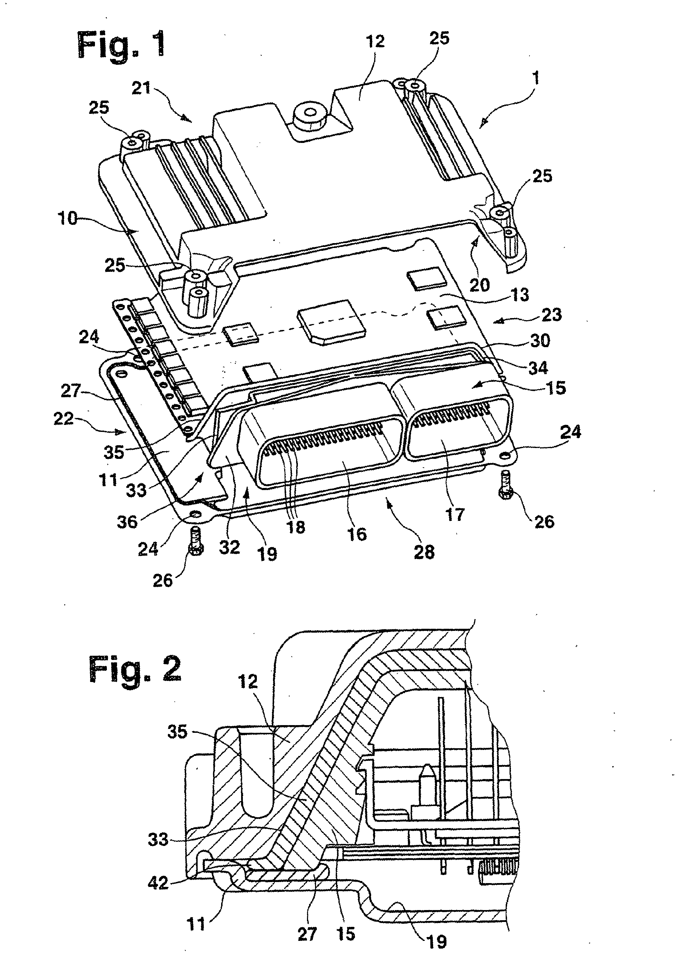

In der Figur 1 sind die Hauptbestandteile eines elektrischen Steuergeräts 1, wie es insbesondere als Schalt- oder Steuergerät in einem KFZ zur Anwendung kommt, dargestellt. Das Steuergerät 1 hat ein Gehäuse 10, das aus einem Bodenteil 11 und einem Deckel 12 besteht. Das Gehäuse 10 umschließt in seinem geschlossenen Zustand eine Leiterplatte 13, die nicht näher dargestellte elektrische bzw. elektronische Bauelemente trägt. Die Leiterplatte 13 ist mit einem Steckerkörper 15 verbunden, der zwei nach außen aus dem Gehäuse 10 ragende Steckerkammern 16, 17 hat. Die Steckerkammern 16, 17 umschließen jeweils Steckerfahnen 18, die mit den elektronischen Bauelementen auf der Leiterplatte 13 elektrisch kontaktiert sind.

Das im wesentlichen ebene Bodenteil 11 besteht bevorzugt aus Blech und weist eine Vertiefung 19 auf, die die an der Unterseite der Leiterplatte 13 angeordneten Bauelemente aufnimmt bzw. zu diesen beabstandet ist. Der Deckel 12, der entweder aus Kunststoff mit einer metallisierten Innenseite zur Verbesserung der EMV-Abschirmung besteht, oder aber als Metall-Druckgußteil ausgebildet ist, weist eine trapezförmige Ausformung 20 zur Aufnahme des Steckerkörpers 15 auf. An der dem Steckerkörper 15 gegenüberliegenden Rückseite 21 des Steuergeräts 1 sowie den beiden Gehäuseseiten 22, 23 sind die Flächen des Bodenteils 11 im wesentlichen eben ausgebildet, während der Deckel 12 mit einer umlaufenden Dichtfeder ausgebildet ist, um eine sichere Überlappung zu ermöglichen.

An den vier Ecken des Gehäuses 10 ist im Bodenteil 11 jeweils eine Bohrung 24, sowie fluchtend dazu im Deckel 12 jeweils eine mit einem Gewinde versehene Aufnahme 25 ausgebildet, so daß das Bodenteil 11 und der Deckel 12 mittels Befestigungsschrauben 26 miteinander verschraubbar sind.

Im Bodenteil 11 ist auf der dem Deckel 12 zugewandten Seite im Randbereich eine erste Dichtung in Form einer umlaufenden, raupenförmig aufgebrachten Dichtmasse 27 angeordnet. Auf der Rückseite 21 sowie an den beiden Gehäuseseiten 22, 23, an denen die entsprechenden Flächen des Bodenteils 11 und des Deckels 12 unmittelbar gegeneinander liegen, bewirkt die Dichtmasse 27 beim Verschrauben der Gehäuseteile miteinander eine luft- und feuchtigkeitsdichte Verbindung zwischen dem Bodenteil 11 und dem Deckel 12. Auf der Vorderseite 28 des Gehäuses 10, aus der der Steckerkörper 15 aus dem Gehäuse 10 herausragt, ist das Gehäuse 10 zur Optimierung der Abdichtung zum Steckerkörper 15 besonders ausgebildet. So weist der Steckerkörper 15 eine der Form der Ausformung 20 angepaßte umlaufende Zwischenwand 30 auf. Die Zwischenwand 30 hat somit entsprechend der trapezförmigen Ausformung 20 eine gerade Oberseite 31, eine dazu parallele Unterseite 32, sowie zwei schräg verlaufende Seitenkanten 33, 34. In zusammengebautem Zustand des Steuergeräts 1 sitzt die Unterseite 32 der Zwischenwand 30 auf dem entsprechenden Abschnitt der Dichtmasse 27 auf, welche auf dem Bodenteil 11 aufgebracht ist. Die Dichtmasse 27 übernimmt somit die Abdichtung zwischen der Unterseite 32, der Zwischenwand 30 und dem Bodenteil 11. Zur Abdichtung der beiden Seitenkanten 33, 34 und der Oberseite 31 der Zwischenwand 30 zum Deckel 12 hin ist eine zweite Dichtung in Form einer ebenfalls raupenförmig aufgebrachten Dichtmasse 35 vorgesehen, welche an den entsprechenden Stellen der Zwischenwand 30 in dem Deckel 12 eingebracht wird.

Während die Abdichtung zwischen der Zwischenwand 30 und dem Deckel 12 mittels der Dichtmasse 35 in den Bereichen der Zwischenwand 30 relativ unkritisch ist, an denen die Zwischenwand 30 nur zum Deckel 12 hin abgedichtet werden muß, bereitete bisher die Abdichtung in den beiden seitlichen Bereichen 36, in denen die Unterseite 32 der Zwischenwand 30 in die schräg verlaufenden Seitenkanten 33, 34 übergeht, Probleme. Die Problematik rührt daher, daß in den Bereichen 36, 37 bei montiertem Steuergerät 1 mit dem Deckel 12, dem Bodenteil 11 und der Zwischenwand 30 bzw. dem Steckerkörper 15 drei Bauteile aufeinandertreffen, die zueinander abgedichtet werden müssen.

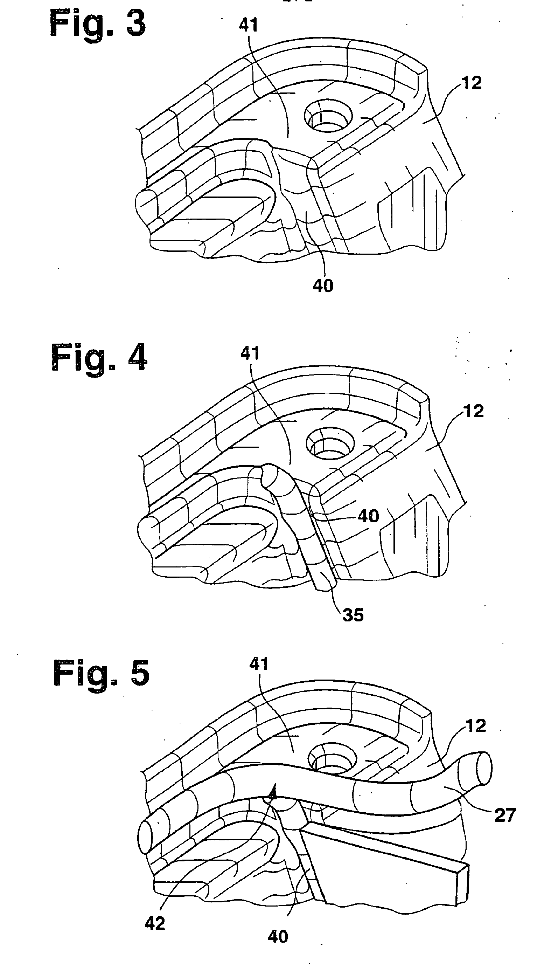

Erfindungsgemäß wird nunmehr vorgeschlagen, in dem Deckel 12 zumindest in den Abschnitten, in denen die beiden seitlichen Bereiche 36 der Zwischenwand 30 angeordnet sind, eine Nut 40 im Deckel 12 auszubilden, in der die Dichtmasse 35 aufgebracht ist. Diese Nut 40 läuft in einer Fläche 41 des Deckels 12 aus, in der auch die Dichtmasse 27 angeordnet ist, derart, daß die in der Nut 40 angeordnete Dichtmasse 35 bei montiertem Deckel 12 direkt auf die Dichtmasse 27 des Bodenteils 11 trifft, bzw. daß ein Überdeckungsbereich 42 der beiden Dichtmassen 27, 35 bei montiertem Steuergerät 1 ausgebildet wird. Dieser Zusammenhang ist in der Figur 5 dargestellt, in der neben dem Deckel 12 mit seiner in der Nut 40 angeordneten Dichtmasse 35 auch die Anordnung der Dichtmasse 27 des Bodenteils 11 (jedoch ohne Bodenteil 11) dargestellt ist.

Um sicherzustellen, daß die beiden Dichtmassen 27, 35 bei der Montage der Bauteile tatsächlich einen Überdeckungsbereich 42 ausbilden, ist vorgesehen, daß der entsprechende Abschnitt der Zwischenwand 30 in der Nut 40 angeordnet ist. Dadurch wird bewirkt, daß beim Zusammenfügen der Bauteile die Zwischenwand 30 die Dichtmasse 35 längs der Nut 40 in Richtung des Überdeckungsbereichs 42 bzw. der Dichtmasse 27 hin verdrängt.

Die Montage des Steuergeräts 1 erfolgt wie folgt: Nachdem in den Deckel 12 die Dichtmasse 35 eingebracht wurde, wird der Deckel 12 mit seiner Oberseite nach unten gelegt. Anschließend wird die Leiterplatte 13 samt dem mit der Leiterplatte 13 verbundenen Steckerkörper 15 derart mit dem Deckel 12 zusammengefügt, daß die Zwischenwand 30 in Deckung mit der Ausformung 20 im Deckel 12 kommt. Dabei verdrängen die entsprechenden Abschnitte der Zwischenwand 30 Dichtmasse 35 aus der Nut 40 in Richtung der Fläche 41 des Deckels 12. Dann wird das mit der Dichtmasse 27 versehene Bodenteil 11 in Deckung mit dem Deckel 12 gebracht, so daß die Bohrungen 24 mit den Aufnahmen 25 fluchten. Zuletzt werden die Befestigungsschrauben 26 angezogen, wobei das Bodenteil 11, der Deckel 12 und die Zwischenwand 30 des Steckerkörpers 15 miteinander verbunden werden und die Dichtmassen 27, 35 verquetscht werden. Danach ist die Montage des Steuergeräts 1 abgeschlossen, wobei die Dichtmassen 27, 35 anschließend aushärten und somit die luft- und feuchtigkeitsdichte Abdichtung des Steuergeräts 1 bzw. des Gehäuses 10 bewerkstelligen.

## Patentansprüche

1. Gehäuse (10) für ein elektrisches Gerät (1), insbesondere ein Schalt- oder Steuergerät in einem Kfz,
- mit wenigstens zwei miteinander verbindbaren Gehäuseteilen (11, 12),
- die eine Öffnung (20) für einen mit einer Leiterplatte (13) verbundenen Steckerkörper (15) ausbilden,
- sowie mit einer im Bereich der Öffnung (20) zwischen dem Steckerkörper (15) und den wenigstens zwei Gehäuseteilen (11, 12) angeordneten Dichtmassen (27, 35),
- die vor dem Zusammenfügen der Gehäuseteile (11, 12) und dem Steckerkörper (15) aufbringbar sind,
**dadurch gekennzeichnet,**
- **dass** in einem Bereich (36) einer der Form der Öffnung (20) angepassten umlaufenden Zwischenwand (30) des Steckerkörpers (15), in dem die wenigstens zwei Gehäuseteile (11, 12) und der Steckerkörper (15) unmittelbar aufeinandertreffen, wenigstens eines der Gehäuseteile (12) in zumindest einem Abschnitt als Nut (40) ausgebildet ist,
- die einen Teil der einen Dichtmasse (35) aufnimmt,
- wobei in die Nut (40) die Zwischenwand (30) des Steckerkörpers (15) eingreift
- und **dass** die Nut (40) bis unmittelbar an das andere Gehäuseteil (11) heranreicht, auf dem die andere Dichtmasse (27) aufgebracht ist.

2. Gehäuse nach Anspruch 1, **dadurch gekennzeichnet, dass** die Zwischenwand (30) des Steckerkörpers (15) in Art einer Nut-Feder-Verbindung in die Nut (40) eingreift.

3. Gehäuse nach Anspruch 1 oder 2, **dadurch gekennzeichnet, dass** die Nut (40) des Gehäuseteils (12) derart angeordnet ist, dass die in der Nut (40) angeordnete Dichtmasse (35) bei Montage der Gehäuseteile (11, 12) auf die Dichtmasse (27) des anderen Gehäuseteils (11) trifft.

4. Gehäuse nach Anspruch 3, **dadurch gekennzeichnet, dass** die eine Dichtmasse (35) in dem die Ausnehmung (40) aufweisenden Gehäuseteil (12) bis in einen Übergängsbereich (41) reicht, in dem bei montiertem anderen Gehäuseteil (11) die andere Dichtmasse (27) verläuft, so dass bei montiertem anderen Gehäuseteil (11) ein Überdeckungsbereich (42) zwischen den beiden Dichtmassen (27, 35) ausgebildet ist.

5. Gehäuse nach einem der Ansprüche 1 bis 4, **dadurch gekennzeichnet, dass** die Dichtmasse eine flüssige bis zähflüssige Dichtmasse (27, 35) ist, die in Raupen- bzw. Schnurform in die Gehäuseteile (11,12) ein- bzw. aufbringbar ist und dass die Dichtmasse (27,35) nach dem Zusammenfügen der wenigstens beiden Gehäuseteile (11, 12) und des Steckerkörpers (15) aushärtet.

## Claims

1. Housing (10) for an electrical device (1), in particular a switching or control device in a motor vehicle,
- having at least two housing parts (11, 12) which can be connected to one another
- and form an opening (20) for a plug body (15) which is connected to a printed circuit board (13),
- and also having sealing compounds (27, 35) which are arranged in the region of the opening (20) between the plug body (15) and the at least two housing parts (11, 12)
- and can be applied before the housing parts (11, 12) and the plug body (15) are joined,
**characterized**
- **in that,** in a region (36) of a circumferential intermediate wall (30), which is matched to the shape of the opening (20), of the plug body (15), in which region the at least two housing parts (11, 12) and the plug body (15) directly meet, at least one section of at least one of the housing parts (12) is in the form of a groove (40)
- which accommodates a portion of one sealing compound (35),
- with the intermediate wall (30) of the plug body (15) engaging in the groove (40),
- and **in that** the groove (40) extends directly up to the other housing part (11) on which the other sealing compound (27) is applied.

2. Housing according to Claim 1, **characterized in that** the intermediate wall (30) of the plug body (15) engages in the groove (40) in the manner of a tongue-and-groove joint.

3. Housing according to Claim 1 or 2, **characterized in that** the groove (40) of the housing part (12) is arranged in such a way that the sealing compound (35) which is arranged in the groove (40) meets the sealing compound (27) of the other housing part (11) when the housing parts (11, 12) are mounted.

4. Housing according to Claim 3, **characterized in that** the one sealing compound (35) in the housing part (12), which has the recess (40), extends into a transition region (41) in which the other sealing compound (27) runs when the other housing part (11) is mounted, and so a region (42) of overlap is formed between the two sealing compounds (27, 35) when the other housing part (11) is mounted.

5. Housing according to one of Claims 1 to 4, **characterized in that** the sealing compound is a liquid to viscous sealing compound (27, 35) which can be introduced into or applied to the housing parts (11, 12) in the form of a bead or cord, and **in that** the sealing compound (27, 35) hardens after the at least two housing parts (11, 12) and the plug body (15) are joined.

## Revendications

1. Boîtier (10) pour un appareil électrique (1), en particulier un appareil de commutation ou de commande dans un véhicule automobile,
- comprenant au moins deux parties de boîtier (11, 12) pouvant être connectées l'une à l'autre,
- qui constituent une ouverture (20) pour un corps enfichable (15) connecté à une plaquette de circuits imprimés (13),
- et comprenant des masses d'étanchéité (27, 35) disposées dans la région de l'ouverture (20) entre le corps enfichable (15) et les au moins deux parties de boîtier (11, 12),
- qui peuvent être appliquées avant l'assemblage des parties de boîtier (11, 12) et du corps enfichable (15),
**caractérisé en ce que**
- dans une région (36) d'une paroi intermédiaire périphérique (30) du corps enfichable (15), adaptée à la forme de l'ouverture (20), dans laquelle les au moins deux parties de boîtier (11, 12) et le corps enfichable (15) sont directement en contact, au moins l'une des parties de boîtier (12) est réalisée au moins dans une portion sous forme de rainure (40),
- qui reçoit une partie de l'une des masses d'étanchéité (35),
- la paroi intermédiaire (30) du corps enfichable (15) venant en prise dans la rainure (40) et
- **en ce que** la rainure (40) s'étend directement jusqu'à l'autre partie de boîtier (11) sur laquelle l'autre masse d'étanchéité (27) est appliquée.

2. Boîtier selon la revendication 1, **caractérisé en ce que** la paroi intermédiaire (30) du corps enfichable (15) vient en prise dans la rainure à la manière d'une connexion par rainure (40) et clavette.

3. Boîtier selon la revendication 1 ou 2, **caractérisé en ce que** la rainure (40) de la partie de boîtier (12) est disposée de telle sorte que la masse d'étanchéité (35) disposée dans la rainure (40) vienne en contact avec la masse d'étanchéité (27) de l'autre partie de boîtier (11) lors du montage des parties de boîtier (11, 12).

4. Boîtier selon la revendication 3, **caractérisé en ce que** l'une des masses d'étanchéité (35) s'étend dans la partie de boîtier (12) présentant l'évidement (40) jusque dans une région de transition (41) dans laquelle s'étend l'autre masse d'étanchéité (27) lorsque l'autre partie de boîtier (11) est montée, de sorte qu'une région de recouvrement (42) soit réalisée entre les deux masses d'étanchéité (27, 35) lorsque l'autre partie de boîtier (11) est montée.

5. Boîtier selon l'une quelconque des revendications 1 à 4, **caractérisé en ce que** la masse d'étanchéité est une masse d'étanchéité (27, 35) fluide à visqueuse, qui peut être introduite ou appliquée sous forme de cordon ou de boudin dans les parties de boîtier (11, 12) et **en ce que** la masse d'étanchéité (27, 35) durcit après l'assemblage des au moins deux parties de boîtier (11, 12) et du corps enfichable (15).
